# EUROPEAN PATENT APPLICATION

(11) **EP 4 514 082 A1**
(43) Date of publication of application: **26.02.2025**
(21) Application number: 23806638.5
(22) Date of filing: 08.04.2023
(51) Int. Cl.: H05K 7/20, G02B 6/42

(54) **CIRCUIT BOARD MODULE AND COMMUNICATION DEVICE**

(30) Priority: 20.05.2022 CN 202210555739
(71) Applicant: Huawei Technologies Co., Ltd., Shenzhen, Guangdong 518129 (CN)
(72) Inventor: LI, Xiaodong, Shenzhen, Guangdong 518129 (CN); LIN, Peiqing, Shenzhen, Guangdong 518129 (CN); LIN, Feng, Shenzhen, Guangdong 518129 (CN)
(74) Representative: Pfenning, Meinig & Partner mbB
(86) International application number: PCT/CN2023/087177
(87) International publication number: WO 2023/221682

(57) **Abstract**

A circuit board module (210) and a communication device (1) are provided, to improve heat dissipation performance of the circuit board module (210), and related to the field of communication technologies. The circuit board module (210) includes a substrate (60), an optical module component (20), an elastic component (70), and a heat sink (80). The optical module component (20) includes a housing (21) and an optical module (22), the housing (21) is arranged on a side of the substrate (60), a hole is provided on a side that is of the housing (21) and that is away from the substrate (60), and the optical module (22) is inserted into the housing (21) from a first end of the housing (21) in a first direction. A first end of the elastic component (70) is fixedly connected to the substrate (60), and a second end of the elastic component (70) is fixedly connected to a side that is of the housing (21) and that faces the substrate (60). The heat sink (80) is arranged on a side that is of the housing (21) and that is away from the substrate (60), and the heat sink (80) is fixedly connected to the substrate (60). A boss (81) opposite to a position of the hole is arranged on a side that is of the heat sink (80) and that faces the substrate (60), and the boss (81) extends into the housing (21) from the hole and is in contact with the optical module (22) inserted into the housing (21).

## Description

This application claims priority to Chinese Patent Application No. 202210555739.3, filed with the China National Intellectual Property Administration on May 20, 2022 and entitled "CIRCUIT BOARD MODULE AND COMMUNICATION DEVICE", which is incorporated herein by reference in its entirety.

### TECHNICAL FIELD

This application relates to the field of communication device technologies, and in particular, to a circuit board module and a communication device.

### BACKGROUND

An optical module is an important part of a communication network, and a main function of the optical module is to implement mutual conversion between an optical signal and an electrical signal. With upgrade and evolution of the communication network, a volume and a transmission rate of communication data in the communication network are significantly increased. This imposes a higher requirement on performance of the optical module. When the performance of the optical module is improved, power consumption of the optical module is also increased. As a result, the optical module generates more heat during work. Therefore, how to improve heat dissipation performance of the optical module has become an urgent technical problem to be resolved.

### SUMMARY

This application provides a circuit board module and a communication device, to improve heat dissipation performance of the circuit board module.

According to a first aspect, this application provides a circuit board module. The circuit board module may include a substrate, an optical module component, an elastic component, and a heat sink. The optical module component may include a housing and an optical module. The housing may be arranged on a side of the substrate, a hole may be provided on a side that is of the housing and that is away from the substrate, and the optical module may be inserted into the housing from a first end of the housing in a first direction. A first end of the elastic component may be fixedly connected to the substrate, and a second end may be fixedly connected to a side that is of the housing and that faces the substrate, so that a floating connection is implemented between the housing and the substrate. The heat sink is arranged on a side that is of the housing and that is away from the substrate, and the heat sink is fixedly connected to the substrate. A boss opposite to a position of the hole may be arranged on a side that is of the heat sink and that faces the substrate. The boss may extend into the housing from the hole and be in contact with the optical module inserted into the housing, so that heat generated by the optical module can be conducted to the heat sink through the boss, and then dissipated by the heat sink to the outside, to implement heat dissipation for the optical module.

In the foregoing solution, the floating connection between the housing and the substrate may be implemented through the elastic component, so that after being inserted into the housing, the optical module can keep abutting against the boss of the heat sink. In this way, the heat generated by the optical module can be quickly transferred to the heat sink through the boss, to implement continuous heat dissipation for the optical module, and improve heat dissipation performance of the circuit board module.

For example, the housing may be an optical cage. When the optical module is inserted into the optical cage, the optical cage may provide a specific electromagnetic shielding function for the optical module, to reduce external electromagnetic interference to the optical module.

In some possible implementation solutions, the circuit board module may further include a connector. The connector may be fastened to a second end that is of the housing and that is opposite to a position of the first end of the housing, and may be electrically connected to the optical module inserted into the housing. In addition, the connector may be electrically connected to the substrate through a flexible conductive component, to implement an electrical connection between the optical module and the substrate. Through the flexible conductive component, when the connector floats when driven by the housing, the flexible conductive component may deform with a position of the connector, to avoid pulling connection ends between the flexible conductive component and the connector and the substrate, and ensure that two ends of the flexible conductive component can be reliably connected to the connector and the substrate.

In some possible implementation solutions, there may be a plurality of optical module components. In this case, bosses that are in one-to-one correspondence with the plurality of optical module components may be arranged on the heat sink, and each boss may extend into a housing of a corresponding optical module component, to dissipate heat for each optical module. Based on an elastic support function of the elastic component, each optical module component in this solution can float freely. Therefore, the optical module in each optical module component can reliably abut against a corresponding boss, so that effective heat dissipation can be implemented for a plurality of optical modules through one heat sink, to help simplify an overall structure of the circuit board module and reduce manufacturing costs of the circuit board module.

In some possible implementation solutions, the circuit board module may further include a fastening plate. The fastening plate may be fixedly arranged on a side that is of the substrate and that is away from the optical module component, to support the substrate and improve structural strength of the substrate.

In some possible implementation solutions, a through hole may be provided on the substrate, and the first end of the elastic component may be fixedly connected to the fastening plate through the through hole. Because the fastening plate is fixedly connected to the substrate, the first end of the elastic component and the substrate can be relatively fastened.

In some possible implementation solutions, the circuit board module may further include a first support plate. The first support plate may be fastened to the side that is of the housing and that faces the substrate, to support the housing. In this case, the second end of the elastic component may be fixedly connected to a side that is of the first support plate and that faces the substrate. Based on a support function of the first support plate, when an elastic force is transferred to the housing, pressure on the housing is small. Therefore, a risk of damage to the housing in a process in which the housing floats when driven by the force can be reduced.

In some other possible implementation solutions, the circuit board module may further include a second support plate. The second support plate and the substrate are arranged in parallel in the first direction, and the second support plate may move relative to the substrate. The housing may be specifically fastened to a side that is of the second support plate and that is away from the fastening plate. In this case, the first end of the elastic component may be fixedly connected to the fastening plate, and the second end may be fixedly connected to a side that is of the second support plate and that faces the fastening plate, to implement elastic support for the second support plate, and the second support plate transfers, to the optical module component, an elastic force applied by the elastic component.

During specific arrangement, the second support plate and the substrate may be independent of each other, or may be connected by using a flexible structure, so that the second support plate can move relative to the substrate.

In some possible implementation solutions, the circuit board module may further include a panel. The panel is fixedly connected to the fastening plate, the panel may be arranged facing the first end of the housing, an avoidance hole is provided on the panel, and the optical module may be inserted into the housing through the avoidance hole. When ventilation is performed on a side of the substrate on which the optical module component is arranged, the panel may be used as an air baffle to guide air, to help improve the heat dissipation efficiency of the circuit board module.

During specific implementation, the panel may be connected to the first end of the housing by using an elastic wave-absorbing material, to block a gap between the first end of the housing and the avoidance hole, and ensure an electromagnetic shielding effect of the housing on the optical module. For example, the elastic wave-absorbing material includes but is not limited to a spring plate, a wave-absorbing sponge, and the like.

In some possible implementation solutions, a side that is of the boss and that faces the first end of the housing may have an oblique surface, and the oblique surface may gradually tilt toward a direction close to the housing in the first direction. When the optical module is inserted into the housing from the first end of the housing, the oblique surface may guide the insertion of the optical module, to improve operation convenience during the insertion.

In some possible implementation solutions, the substrate may be fixedly connected to the heat sink by using a first pillar. For example, the first pillar may be a stud, another rigid cylinder structure, or the like.

To implement reliable support for the heat sink, there may be a plurality of first pillars, and the plurality of first pillars may be evenly arranged between the heat sink and the substrate.

In some possible implementation solutions, a heat pipe may be embedded in the heat sink. The heat pipe may be used to quickly conduct heat that is on the heat sink and that is concentrated at the boss to each position of the heat sink, to improve temperature uniformity of the heat sink, improve heat dissipation efficiency of the heat sink, and enhance a heat dissipation effect for the optical module.

In some other possible implementation solutions, the heat sink may alternatively be a water-cooled heat sink or an air-cooled heat sink of another structure.

According to a second aspect, this application further provides a communication device. The communication device may include the circuit board module in any one of the possible implementation solutions of the first aspect. Because the circuit board has good heat dissipation performance, running reliability of the communication device is also improved.

In some possible implementation solutions, there may be a plurality of circuit board modules, and the plurality of circuit board modules may be arranged in parallel. The communication device may further include a backplane. The backplane may be arranged on a side of each circuit board in a first direction, and the backplane is arranged away from a first end of a housing. The backplane may be electrically connected to each circuit board module, so that the circuit board modules may communicate with each other through the backplane.

In some possible implementation solutions, the communication device may further include a fan. The fan may supply air to an air duct formed between adjacent circuit board modules, to take away heat generated when the circuit board module works.

### BRIEF DESCRIPTION OF DRAWINGS

FIG. 1 is a diagram of a structure of a communication device according to an embodiment of this application;
FIG. 2 is a diagram of a structure of a board shown in FIG. 1;
FIG. 3 is a side view of the board shown in FIG. 2;
FIG. 4 is a side view of a circuit board module according to an embodiment of this application;
FIG. 5 is a diagram of a structure of an elastic component according to an embodiment of this application;
FIG. 6 is a diagram of a structure of the circuit board module shown in FIG. 4 when an optical module is not inserted;
FIG. 7 is a diagram of a structure of the circuit board module shown in FIG. 4 in a process of inserting an optical module;
FIG. 8 is a diagram of a structure of another circuit board module according to an embodiment of this application;
FIG. 9 is a diagram of a structure of another circuit board module according to an embodiment of this application;
FIG. 10 is a diagram of a structure of another circuit board module according to an embodiment of this application;
FIG. 11 is a top view of a circuit board module according to an embodiment of this application; and
FIG. 12 is a diagram of a structure of a cross-section of the circuit board module shown in FIG. 11 at A-A.

### Reference numerals:

1-Communication device; 100-Housing; 200-Communication body; 210-Board (circuit board module); 220-Backplane; 10-Chip;
20-Optical module component; 21-Housing; 211-First end of the housing; 212-Second end of the housing; 22-Optical module;
30-Inter-board connector; 40-Power supply; 50-Central processing unit; 60-Substrate; 61-Fastening plate; 611-Second pillar;
62-Through hole; 63-Panel; 631-Avoidance hole; 64-First support plate; 65-Second support plate; 70-Elastic component;
80-Heat sink; 81-Boss; 811-Oblique surface; 82-Fin; 83-First pillar; 90-Connector; and 91-Flexible conductive component.

### DESCRIPTION OF EMBODIMENTS

To make the objectives, the technical solutions, and advantages of this application clearer, the following further describes this application in detail with reference to the accompanying drawings. Example implementations can be implemented in a plurality of forms and should not be construed as being limited to implementations described herein. On the contrary, these implementations are provided to make this application more comprehensive and complete and fully convey the concept of the example implementations to a person skilled in the art. Identical reference numerals in the accompanying drawings denote identical or similar structures. Therefore, repeated descriptions thereof are omitted. Expressions of locations and directions in this application are described by using the accompanying drawings as an example. However, changes may also be made as required, and all the changes fall within the protection scope of this application. The accompanying drawings in this application are merely used to illustrate relative position relationships and do not represent an actual scale.

It should be noted that specific details are provided in the following descriptions for ease of fully understanding this application. However, this application can be implemented in a plurality of manners different from those described herein, and a person skilled in the art can perform similar promotion without departing from the connotation of this application. Therefore, this application is not limited to the following disclosed specific implementations. The following descriptions of this specification are good implementations of implementing this application. Certainly, the descriptions are intended to describe the general principle of this application, and are not intended to limit the scope of this application. The protection scope of this application shall be defined by the appended claims.

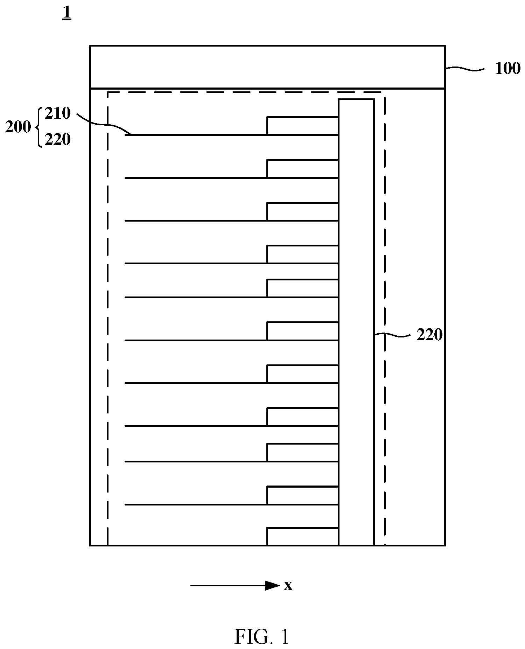

FIG. 1 is a diagram of a structure of a communication device according to an embodiment of this application. In this embodiment of this application, the communication device 1 may be an optical fiber transceiver, a switch, an optical fiber router, an optical fiber network adapter, a base station, or the like, or may be another optical fiber device having a communication function. This is not limited in this application. The communication device may include a housing 100, and a communication body 200 and a power supply apparatus (not shown) that are located in the housing 100. The power supply apparatus may be arranged on the top of the communication body 200, to supply power to the communication body 200.

A plurality of slots may be arranged in the housing 100, and the plurality of slots may be parallel to each other. For example, the slots may be arranged horizontally in parallel or longitudinally in parallel. This is not limited in this application. In the embodiment shown in FIG. 1, an example in which the plurality of slots are arranged horizontally in parallel is used for description. The communication body 200 may include a plurality of boards 210 and a backplane 220. The plurality of boards 210 may be inserted into the slots in one-to-one correspondence. For example, the plurality of boards 210 may include a service board and a control board. An insertion direction of the board 210 is defined as a first direction x, and the backplane may be arranged on a side of each board 210 in the first direction x.

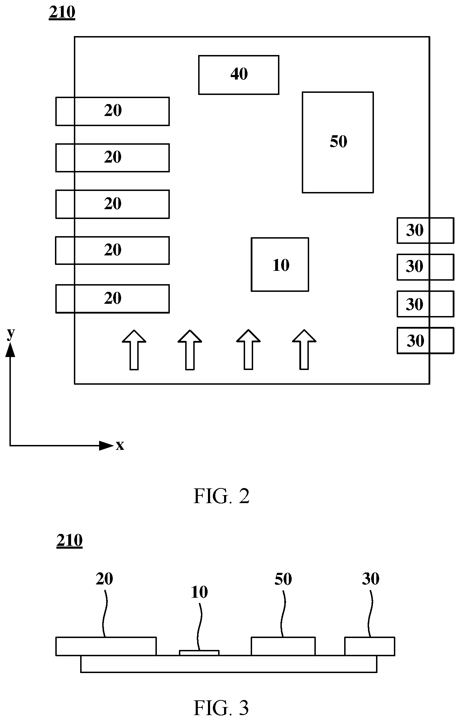

FIG. 2 is a diagram of a structure of the board shown in FIG. 1, and FIG. 3 is a side view of the board shown in FIG. 2. Refer to FIG. 1 to FIG. 3 together. A chip 10, an optical module component 20, and an inter-board connector 30 may be arranged on the board 210. The optical module component 20 may be arranged at an end that is of the board 210 and that is away from the backplane 220, so that the board 210 may communicate with an external device through the optical module component 20. The inter-board connector 30 may be arranged at an end that is of the board 210 and that is close to the backplane 220. In other words, the optical module component 20 and the inter-board connector 30 may be respectively arranged at two ends of the board 210 in the first direction x. The board 210 may be electrically connected to the backplane 220 through the inter-board connector 30. During specific implementation, a male socket of the inter-board connector 30 may be arranged on the board 210, and a female socket may be arranged on the backplane 220. When the board 210 is inserted into the slot, the board 210 and the backplane 220 may be connected by matching the male socket and the female socket. Certainly, in some other implementations, the male socket of the inter-board connector 30 may alternatively be arranged on the backplane 220, and correspondingly, the female socket of the inter-board connector 30 may be arranged on the board 210, provided that the board 210 can be connected to the backplane 220. A manner of arranging the inter-board connector 30 is not specifically limited in embodiments of this application.

In some embodiments, components such as a power supply 40 and a central processing unit (central processing unit, CPU) 50 may be further arranged on the board 210. The power supply 40 may be configured to supply power to an electrical device on the board 210, to ensure normal operation of the board 210. The CPU 50 may be configured to control the board 210 to perform service receiving and sending, speed adjustment, emergency handling, and the like.

In addition, the communication device 1 may further include a fan (not shown), configured to dissipate heat for the communication body 200. For example, inside the communication device 1, an air duct may be formed between adjacent boards 210. The fan may be arranged at an end of each air duct, to supply air to each air duct and take away heat generated when the board 210 works. During specific implementation, each air duct may be arranged in a second direction y. The second direction y and the first direction x may be perpendicular to each other.

When the communication device 1 works, the board 210 may receive an external optical signal through the optical module component 20, convert the optical signal into an electrical signal, and then send the electrical signal to the chip 10 for processing. The chip 10 transfers the processed signal to the backplane 220 through the inter-board connector 30, and then the backplane 220 transfers the processed signal to another board 210. After being processed by a chip 10 on the another board 210, an optical module component 20 of the another board 210 converts the processed signal into an optical signal and then outputs the optical signal to the outside. In this case, the communication device 1 implements a network switching or network processing function.

With upgrade and evolution of a communication network, a volume and a transmission rate of communication data in the communication network are significantly increased. To ensure a communication requirement of the communication device, performance of the optical module component 20 may be optimized, and deployment density of optical module components 20 on the board 210 may be increased. For example, FIG. 2 shows a case in which five optical module components 20 are arranged on the board 210. During specific implementation, these optical module components 20 may be arranged in parallel on the board in the second direction y, and the board 210 may communicate with an external device through each optical module component 20, to increase an overall data transmission volume of the communication device. It should be noted that a quantity of optical module components 20 shown in FIG. 2 and the following accompanying drawings is merely used for description, and does not constitute a limitation on an actual quantity of optical module components 20 on the board 210.

It may be understood that, when the performance of the optical module component 20 is improved, power consumption of the optical module component 20 is also increased. As a result, the optical module component 20 generates more heat during work. Therefore, heat dissipation for the optical module component 20 is particularly important. In addition, in a high-density deployment scenario of optical module components 20, temperatures of the optical module components 20 may be cascaded. Specifically, a temperature of an optical module component 20 located in a downstream of the air duct is clearly higher than a temperature of an optical module component 20 located in an upstream of the air duct. This is very unfavorable to heat dissipation for the entire board 210.

For the foregoing case, an embodiment of this application provides a circuit board module that may be used as the board 210 in the foregoing communication device. In the circuit board module, optical module components are arranged to float as a whole, so that a problem of temperature cascading of the optical module components in a high-density deployment scenario can be further resolved while a heat dissipation effect for the optical module components is ensured, to improve overall heat dissipation performance of the circuit board module. The following specifically describes the circuit board module provided in embodiments of this application with reference to the accompanying drawings. It should be noted that, in the following, a number of the circuit board module is the same as a number of the board 210.

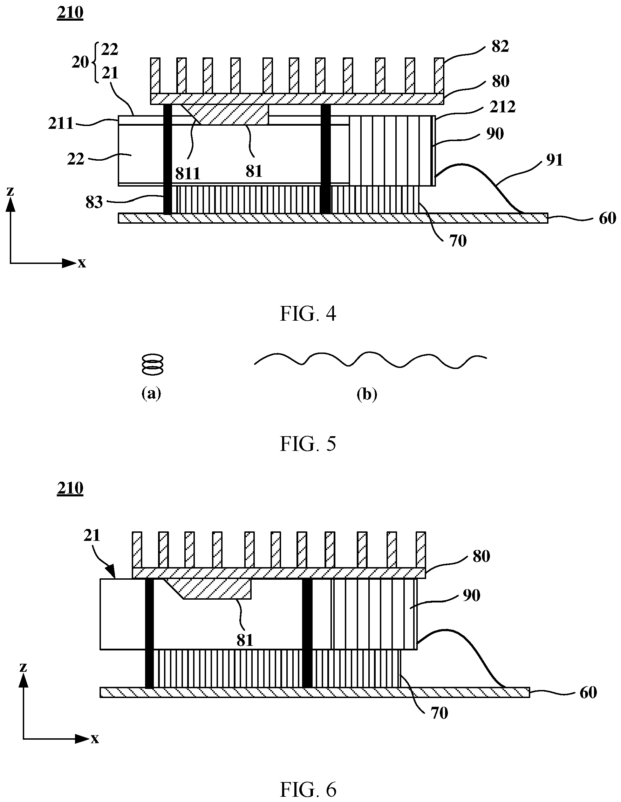

FIG. 4 is a side view of a circuit board module according to an embodiment of this application. In this embodiment of this application, the circuit board module 210 may include a substrate 60, an optical module component 20, an elastic component 70, and a heat sink 80. A height direction of the circuit board module 210 is defined as a third direction z, the substrate 60, the optical module component 20, and the heat sink 80 may be sequentially arranged in the third direction z, and the elastic component 70 may elastically connect the substrate 60 to the optical module component 20, so that the optical module component 20 can float up and down relative to the substrate 60 in the third direction z. The heat sink 80 may be fixedly connected to the substrate 60, to dissipate heat for the optical module component 20. It should be noted that FIG. 4 and the following related accompanying drawings only schematically show some components of the circuit board module 210, and actual shapes, actual sizes, actual positions, and actual structures of these components are not limited by FIG. 4 and the following accompanying drawings.

During specific implementation, the substrate 60 may be a rigid circuit board, or may be a flexible circuit board, or may be a rigid-flex circuit board. When the substrate 60 is the flexible circuit board or the rigid-flex circuit board, a reinforcement plate may be arranged on a side of the substrate 60, to ensure structural strength of the substrate 60. The substrate 60 may be an FR-4 dielectric plate, or may be a Rogers (Rogers) dielectric plate, or may be an FR-4 and Rogers mixed dielectric plate, or the like.

The optical module component 20 may include a housing 21 and an optical module 22. The housing 21 is located on a side of the substrate 60. In the first direction x, the housing 21 includes a first end 211 and a second end 212 that are opposite to each other, and the optical module 22 may be inserted into the housing 21 from the first end 211 of the housing 21. For example, the housing 21 may be specifically an optical cage. When the optical module 22 is inserted into the optical cage, the optical cage may provide a specific electromagnetic shielding function for the optical module, to reduce external electromagnetic interference to the optical module 22.

When the optical module 22 is electrically connected to the circuit board module 210, the circuit board module 210 may further include a connector 90. The connector 90 may be fastened to the second end 212 of the housing 21, and the connector 90 is electrically connected to the substrate 60, to be electrically connected to a chip arranged on the substrate 60. An edge connector may be arranged at an end that is of the optical module 22 and that faces the connector 90, and a pin may be arranged on the connector 90. In a process of inserting the optical module 22 into the housing 21, the edge connector of the optical module 22 may be connected to the pin of the connector 90 one by one in an aligned manner, to implement signal transmission between the optical module 22 and the connector 90. It may be understood that, because a floating connection is implemented between the housing 21 and the substrate 60, the connector 90 floats with the housing 21 relative to the substrate 60. To ensure electrical connection stability between the connector 90 and the substrate 60, a flexible conductive component 91 may be used to electrically connect the connector 90 to the substrate 60. When the housing 21 drives the connector 90 to float, the flexible conductive component 91 may deform with a change of a position of the connector 90, to avoid pulling connection ends between the flexible conductive component 91 and the connector 90 and the substrate 60, and ensure that two ends of the flexible conductive component 91 can be reliably connected to the connector 90 and the substrate 60. For example, the flexible conductive component 91 may be a flexible cable, a flexible circuit board, or the like.

In some embodiments, in the third direction z, the first end of the elastic component 70 may be fixedly connected to the substrate 60, and the other end may be fixedly connected to a side that is of the housing 21 and that faces the substrate 60, so that a floating connection is implemented between the housing 21 and the substrate 60 in the third direction z. A specific type of the elastic component 70 is not limited. For example, as shown in FIG. 5, the elastic component 70 may be a spring or a precision spring shown in (a) in FIG. 5, or an elastomer shown in (b) in FIG. 5, or may be corrugated steel, or may be some other metal or non-metallic mechanical components with elasticity, or the like. Examples are not listed one by one herein.

Still refer to FIG. 4. A side that is of the housing 21 and that faces the heat sink 80, that is, the top of the housing 21, may be provided with a hole, and the hole may connect the inside of the housing 21 to the outside. A boss 81 opposite to a position of the hole may be arranged on a side that is of the heat sink 80 and that faces the housing 21. The boss 81 may extend into the housing 21 from the hole and be in contact with the optical module 22 inserted into the housing 21, so that heat generated by the optical module 22 is conducted to the heat sink 80 through the boss 81, and then dissipated by the heat sink 80 to the outside, to implement heat dissipation for the optical module 22.

During specific implementation, the heat sink 80 may be prepared by using a metal material such as copper or aluminum with good heat conduction performance, to improve a heat dissipation effect of the heat sink 80. In addition, a fin 82 may be further arranged on a side that is of the heat sink 80 and that is away from the optical module component 20. In this way, an outer surface area of the heat sink 80 can be effectively increased, to improve heat exchange efficiency between the heat sink 80 and external air, and further improve the heat dissipation effect of the heat sink 80. When the heat sink 80 is fixedly connected to the substrate 60, the circuit board module 210 may further include a first pillar 83, and two ends of the first pillar 83 are respectively connected to the heat sink 80 and the substrate 60, so that the heat sink 80 and the substrate 60 can be relatively fastened. It may be understood that, to implement reliable support for the heat sink 80, there may be a plurality of first pillars 83, and the plurality of first pillars 83 may be evenly arranged between the heat sink 80 and the substrate 60. For example, the first pillar 83 may be a stud, another rigid cylinder structure, or the like.

In some implementations, a high heat conductivity structure may be further embedded in the heat sink 80. The high heat conductivity structure may be used to quickly conduct heat that is on the heat sink 80 and that is concentrated at the boss 81 to each position of the heat sink 80, to improve temperature uniformity of the heat sink 80, improve the heat dissipation efficiency of the heat sink 80, and enhance a heat dissipation effect for the optical module 22. For example, the high heat conductivity structure may be a heat pipe, graphite, or the like.

Certainly, in some other implementations, the heat sink 80 may alternatively be a water-cooled heat sink or an air-cooled heat sink of another structure. This is not limited in this application. Specifically, the heat sink 80 may be selected according to a heat dissipation requirement of the optical module 22. Details are not described herein again.

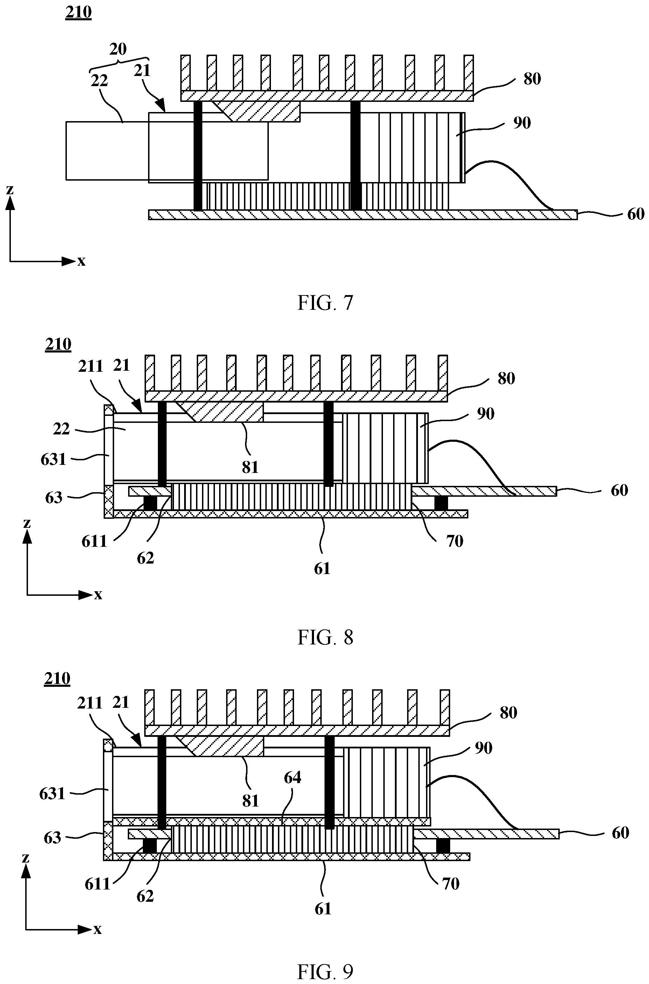

FIG. 6 is a diagram of a structure of the circuit board module shown in FIG. 4 when the optical module is not inserted, and FIG. 7 is a diagram of a structure of the circuit board module shown in FIG. 4 in a process of inserting the optical module. Before the optical module 22 is inserted, the elastic component 70 is in an energy-release state, and the boss 81 may extend into the housing 21 from the hole at the top of the housing 21. In this case, a distance between an end face of the boss 81 and the bottom of the housing 21 is less than a height of the optical module 22. When the optical module 22 is inserted into the housing 21, the boss 81 applies a downward force to the optical module 22, to push the optical module component 20 and the connector 90 to move downward as a whole. The elastic component 70 is also compressed, and changes from the energy-release state to an energy-storage state. In this case, the elastic component 70 may apply an upward force to the optical module component 20. Under the force, the top of the optical module 22 may keep abutting against the end face of the boss 81, and therefore, reliable contact is implemented between the optical module 22 and the boss 81. After the optical module 22 is inserted in position, the optical module 22 is connected to the connector 90 in an aligned manner, and the optical module 22 is powered on and starts to work. In this case, heat generated by the optical module 22 may be transferred to the heat sink 80 through the boss 81, so that the heat sink 80 dissipates heat for the optical module 22.

In some embodiments, a side that is of the boss 81 and that faces the first end 211 of the housing 21 may have an oblique surface 811, and in the first direction x, the oblique surface 811 may gradually tilt toward a direction close to the housing 21, and is connected to an end face of a side that is of the boss 81 and that faces the housing 21. In this case, a cross section of the boss 81 on an xz plane is approximately a trapezoidal structure. When the optical module 22 is inserted into the housing from the first end 211 of the housing 21, the oblique surface 811 may guide the insertion of the optical module 22, to improve operation convenience during the insertion.

In addition, a friction-resistant material may be further arranged on the end face of the side that is of the boss 81 and that faces the housing, to reduce abrasion caused by repeated insertion and removal of the optical module 22, so that the optical module 22 can keep abutting against the end face of the boss 81 in an inserted state. It should be noted that, because heat generated by the optical module 22 needs to be transferred to the heat sink 80 through the boss 81, the friction-resistant material arranged on the end face of the boss 81 can further have good heat conductivity while ensuring friction resistance, to improve heat conduction efficiency between the optical module 22 and the heat sink 80. For example, the friction-resistant material may be specifically graphite.

FIG. 8 is a diagram of a structure of another circuit board module according to an embodiment of this application. In this embodiment, the circuit board module 210 may further include a fastening plate 61. The fastening plate 61 may be arranged on a side that is of the substrate 60 and that is away from the optical module component 20, and support the substrate 60. In some implementations, there may be an interval between the fastening plate 61 and the substrate 60. In this case, a second pillar 611 may be arranged in the interval between the fastening plate 61 and the substrate 60, so that the fastening plate 61 and the substrate 60 are relatively fastened. For example, the second pillar 611 may be a stud, another rigid cylinder structure, or the like. To implement reliable support for the substrate 60, there may be a plurality of second pillars 611, and the plurality of second pillars 611 may be evenly arranged between the fastening plate 61 and the substrate 60, to improve force uniformity of the substrate 60. In this case, a through hole 62 may be provided on the substrate 60, and the first end of the elastic component 70 may be fixedly connected to the fastening plate 61 through the through hole 62, to be relatively fastened to the substrate 60, and a second end of the elastic component 70 is fixedly connected to the housing 21, to implement elastic support for the housing 21.

Certainly, in some other implementations, the fastening plate 61 and the substrate 60 may alternatively be arranged in a fitting manner, that is, the substrate 60 may be directly fastened on the fastening plate 61. In this case, the through hole 62 may also be provided on the substrate 60, so that the first end of the elastic component 70 may be fixedly connected to the fastening plate 61.

Still refer to FIG. 8. The circuit board module 210 may further include a panel 63. The panel 63 may be arranged facing the first end 211 of the housing 21, and the panel 63 is fixedly connected to the fastening plate 61. An avoidance hole 631 is provided on the panel 63, and the optical module 22 may be inserted into the housing 21 through the avoidance hole 631. It may be understood that, when the circuit board module 210 is inserted into the slot of the communication device, the panel 63 and the backplane are arranged opposite to each other in the first direction x. In this way, inside the communication device, two adjacent layers of circuit board modules 210 may be enclosed with the panel 63 and the backplane to form an air duct. It may be understood that the air duct is arranged in the second direction. When heat dissipation is performed on the optical module 22, air may flow from an end of the air duct to the other end in the second direction, to take away heat gathered on the heat sink 80, so as to implement continuous heat dissipation for the optical module 22.

In addition, because the optical module 22 moves with the housing 21 in the third direction z after being inserted into the housing 21, during specific implementation, a height of the avoidance hole 631 may be designed to be greater than a height of the optical module 22, to avoid interference between the optical module 22 and the panel 63. In this case, the side that is of the panel 63 and that faces the housing 21 may be connected to the first end 211 of the housing 21 by using the elastic wave-absorbing material. The elastic wave-absorbing material may deform with movement of the housing 21, to block a gap between the first end 211 of the housing 21 and the avoidance hole 631 in the third direction z, and ensure an electromagnetic shielding effect of the housing 21 on the optical module 22. During specific implementation, the elastic wave-absorbing material includes but is not limited to a spring plate, a wave-absorbing sponge, and the like.

FIG. 9 is a diagram of a structure of another circuit board module according to an embodiment of this application. In this embodiment, the circuit board module 210 may further include a first support plate 64. The first support plate 64 may be fastened to the side that is of the housing 21 and that faces the substrate 60, to support the housing 21. It may be understood that, in the first direction x, the first support plate 64 may further extend to the bottom of the connector 90, to support the connector 90 together. In this case, the elastic component 70 may be specifically arranged between the fastening plate 61 and the first support plate 64, the first end of the elastic component 70 is fixedly connected to the fastening plate 61 through a through hole on the substrate 60, and a second end is fixedly connected to a side that is of the first support plate 64 and that faces the substrate 60, to implement elastic support for the first support plate 64. The first support plate 64 transfers, to the optical module component 20 and the connector 90, an elastic force applied by the elastic component 70, so that the first support plate 64, the optical module component 20, and the connector 90 can float up and down as a whole relative to the substrate 60. Based on a support function of the first support plate 64, when the elastic force is transferred to the housing 21, pressure on the housing 21 is small. Therefore, a risk of damage to the housing 21 in a process in which the housing 21 floats when driven by the force can be reduced, and overall structural strength of the circuit board module 210 can be improved.

During specific implementation, the first support plate 64 may be prepared by using a material having specific strength, to ensure reliability of supporting the optical module component 20 and the connector 90. For example, the first support plate 64 may be a metal plate, a plastic plate, or the like.

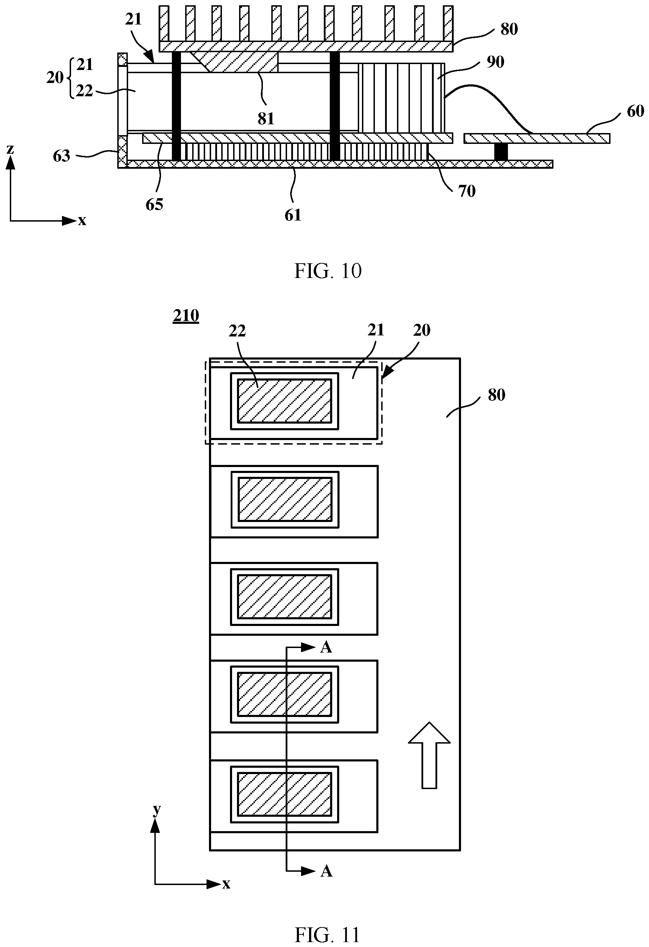

FIG. 10 is a diagram of a structure of another circuit board module according to an embodiment of this application. In this embodiment, the circuit board module 210 may include a second support plate 65. The second support plate 65 and the substrate 60 are arranged in parallel in the first direction x, and the second support plate 65 is located on a side that is of the substrate 60 and that is close to the panel 63. The housing 21 and the connector 90 may be specifically fastened to the second support plate 65. The second support plate 65 and the substrate 60 may be relatively movable. During specific implementation, the second support plate 65 and the substrate 60 may be independent of each other, that is, there may be no connection relationship between the second support plate 65 and the substrate 60. Alternatively, the second support plate 65 and the substrate 60 may be connected by using a flexible structure, for example, may be connected by using a spring, a rubber, or the like. In addition, the second support plate 65 and the substrate 60 may be dielectric plates of a same type. For example, the second support plate 65 and the substrate 60 may be formed by cutting a same dielectric plate. Alternatively, the second support plate 65 may be a metal plate, a plastic plate, or the like. This is not specifically limited in this application.

The elastic component 70 may be arranged between the fastening plate 61 and the second support plate 65, the first end of the elastic component 70 is fixedly connected to the fastening plate 61, and a second end is fixedly connected to a side that is of the second support plate 65 and that faces the fastening plate 61, to implement elastic support for the second support plate 65, and the second support plate 65 transfers, to the optical module component 20 and the connector 90, an elastic force applied by the elastic component 70, so that the second support plate 65, the optical module component 20, and the connector 90 can float up and down as a whole relative to the substrate 60. Similar to the function of the first support plate, in this embodiment, based on a support function of the second support plate 65, when an elastic force is transferred to the housing 21, pressure on the housing 21 is small. Therefore, a risk of damage to the housing 21 in a process in which the housing 21 floats when driven by the force can be reduced, and overall structural strength of the circuit board module 210 can be improved.

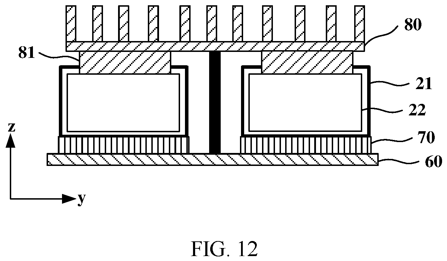

FIG. 11 is a top view of a circuit board module according to an embodiment of this application, and FIG. 12 is a diagram of a structure of a cross-section of the circuit board module shown in FIG. 11 at A-A. As described above, to increase a volume of communication data of the communication device, a plurality of optical module components 20 may be arranged on the circuit board module 210 for data transmission. In the embodiment shown in FIG. 11, five optical module components 20 are used as an example for description. During specific implementation, the five optical module components 20 may be arranged in parallel in the second direction y. In this case, a plurality of bosses 81 that are in one-to-one correspondence with the plurality of optical module components may be arranged on the heat sink 80, and each boss 81 may extend into a housing 21 of a corresponding optical module component 20 through a hole of the housing 21 of the optical module component 20, to dissipate heat for each optical module 22.

Based on an elastic support function of the elastic component 70, each optical module component 20 can freely move in the third direction z. Even if a specific manufacturing tolerance exists in the third direction z of each optical module component 20, the tolerance may be absorbed by the lower elastic component 70, so that the optical module 22 in each optical module component 20 can reliably abut against the corresponding boss 81, to implement effective heat dissipation for each optical module 22 by the heat sink 80. In other words, for a high-density deployment scenario of optical modules 22, according to a solution based on a floating design of the optical module component 20 provided in this embodiment of this application, one heat sink 80 may be used to effectively dissipate heat for the plurality of optical modules 22, to help simplify an overall structure of the circuit board module 210 and reduce manufacturing costs of the circuit board module 210.

It should be noted that, in some embodiments, each optical module component 20 may be elastically supported on the substrate 60 through one or more elastic components 70. In this way, motion of each optical module component 20 in the third direction z may be decoupled, to reduce mutual impact between adjacent optical module components 20, and further improve contact reliability between each optical module 22 and a corresponding boss 81.

Still refer to FIG. 11. For a communication device in which the circuit board module 210 is used, a fan of the communication device may be arranged on any side of the circuit board module 210 in the second direction y. This is not limited in this application. For example, when the fan is arranged at the bottom of the circuit board module 210, and an air supply direction is from bottom to top, an end close to the bottom of the circuit board module 210 may be understood as an upstream of the air duct, and an end close to the top of the circuit board module 210 may be understood as a downstream of the air duct. For example, power consumption of the optical module 22 is 40 W, a height of an internal slot of the communication device is 1.3 feet (inches), and a fan wind speed is 3 m/s. In this embodiment of this application, a temperature of a service chip of each optical module in a heat dissipation solution based on a floating design of an optical module and a temperature of a service chip of each optical module in a conventional solution of a single heat sink are separately detected, and heat dissipation effects of the two solutions are analyzed. Results are shown in Table 1.

**Table 1**

| | Optical module/40 W | Conventional solution: Housing temperature of an optical module component at 45°C/°C | Solution of this application: Housing temperature of an optical module component at 45°C/°C | Optimization benefit/°C |
|---|---|---|---|---|
| Circuit board module | Optical module 1 | 93.2 | 93.6 | +0.4 |
| | Optical module 2 | 96.1 | 94.7 | -1.4 |
| | Optical module 3 | 99.6 | 95.5 | -4.1 |
| | Optical module 4 | 102.6 | 96.4 | -6.2 |
| | Optical module 5 | 104.6 | 96.5 | -8.1 |

It can be learned from the foregoing table that, according to the heat dissipation solution based on the floating design of the optical module component 20 provided in this embodiment of this application, a temperature cascading problem of the optical modules 22 is significantly improved. In addition, because a design of the overall heat sink 80 solution can effectively increase a heat dissipation area, a temperature difference between the optical modules 22 is also greatly reduced. Compared with a conventional heat dissipation solution, a temperature of the housing 21 of the optical module component 20 located at the downstream of the air duct may be reduced by 8.1°C, and a heat dissipation effect is improved by 20%.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board module, comprising a substrate, an optical module component, an elastic component, and a heat sink, wherein
the optical module component comprises a housing and an optical module, the housing is arranged on a side of the substrate, a hole is provided on a side that is of the housing and that is away from the substrate, and the optical module is inserted into the housing from a first end of the housing in a first direction;
a first end of the elastic component is fixedly connected to the substrate, and a second end of the elastic component is fixedly connected to a side that is of the housing and that faces the substrate; and
the heat sink is arranged on a side that is of the housing and that is away from the substrate, the heat sink is fixedly connected to the substrate, a boss opposite to a position of the hole is arranged on a side that is of the heat sink and that faces the substrate, and the boss extends into the housing from the hole and is in contact with the optical module inserted into the housing.

2. The circuit board module according to claim 1, further comprising a connector, wherein the connector is fastened to a second end of the housing, the connector is electrically connected to the substrate through a flexible conductive component, and the connector is electrically connected to the optical module inserted into the housing; and
the second end of the housing and the first end of the housing are arranged opposite to each other in the first direction.

3. The circuit board module according to claim 1 or 2, wherein there are a plurality of optical module components; and
a plurality of bosses that are in one-to-one correspondence with the plurality of optical module components are arranged on the heat sink, and each boss extends into a housing of a corresponding optical module component.

4. The circuit board module according to any one of claims 1 to 3, further comprising a fastening plate, wherein the fastening plate is fixedly supported on a side that is of the substrate and that is away from the optical module component.

5. The circuit board module according to claim 4, wherein a through hole is provided on the substrate, and the first end of the elastic component is fixedly connected to the fastening plate through the through hole.

6. The circuit board module according to claim 4 or 5, further comprising a first support plate, wherein the first support plate is fixedly supported on the side that is of the housing and that faces the substrate; and
the second end of the elastic component is fixedly connected to the first support plate.

7. The circuit board module according to claim 4, further comprising a second support plate, wherein the second support plate and the substrate are arranged in parallel in the first direction, the second support plate moves relative to the substrate, and the housing is fastened to a side that is of the second support plate and that is away from the fastening plate; and
the first end of the elastic component is fixedly connected to the fastening plate, and the second end of the elastic component is fixedly connected to a side that is of the second support plate and that faces the fastening plate.

8. The circuit board module according to claim 7, wherein the second support plate and the fastening plate are independently arranged; or the second support plate and the fastening plate are connected by using a flexible structure.

9. The circuit board module according to any one of claims 3 to 8, further comprising a panel, wherein the panel is fixedly connected to the fastening plate, the panel is arranged facing the first end of the housing, an avoidance hole is provided on the panel, and the optical module is inserted into the housing through the avoidance hole.

10. The circuit board module according to claim 9, wherein the panel is connected to the first end of the housing by using an elastic wave-absorbing material.

11. The circuit board module according to any one of claims 1 to 10, wherein a side that is of the boss and that faces the first end of the housing has an oblique surface, and the oblique surface gradually tilts toward a direction close to the housing in the first direction.

12. The circuit board module according to any one of claims 1 to 11, further comprising a first pillar, wherein two ends of the first pillar are respectively fixedly connected to the substrate and the heat sink.

13. The circuit board module according to any one of claims 1 to 12, wherein a heat pipe is embedded in the heat sink.

14. A communication device, comprising the circuit board module according to any one of claims 1 to 13.

15. The communication device according to claim 14, wherein there are a plurality of circuit board modules, and the plurality of circuit board modules are arranged in parallel; and
the communication device further comprises a backplane, the backplane is located on a side of each circuit board in a first direction, the backplane is arranged away from a first end of a housing, and the backplane is electrically connected to each circuit board module.

16. The communication device according to claim 15, wherein an air duct is formed between adjacent circuit board modules; and
the communication device further comprises a fan, and the fan is configured to supply air to each air duct.
